# EUROPEAN PATENT APPLICATION

(11) **EP 4 270 789 A1**
(43) Date of publication of application: **01.11.2023**
(21) Application number: 22170373.9
(22) Date of filing: 27.04.2022
(51) Int. Cl.: H03K 17/96

(54) **CAPACITIVE TOUCH SENSOR**

(71) Applicant: NXP USA, Inc., Austin TX 78735 (US)
(72) Inventor: Galda, Michael, 5656AG Eindhoven (NL); Krenek, Pavel, 5656AG Eindhoven (NL); Sadek, Pavel, 5656AG Eindhoven (NL)
(74) Representative: Miles, John Richard

(57) **Abstract**

A capacitive touch sensor is described having two spring electrodes. One spring (inner spring) with smaller diameter is placed inside a second spring with larger diameter (outer spring). Both springs together function as single capacitive touch sensor, which may improve the sensor performance and robustness against parasitic environmental effects such as the presence of liquid on the sensor or control panel.

## Description

### FIELD

This disclosure relates to a capacitive touch sensor.

### BACKGROUND

Capacitive touch sensing has become a common place technology for user input in human-machine interfaces. The basic element of the capacitive touch sensor is the electrode which includes an area of conductive material with dielectric material on the top for example plastic or glass which is touched by the user. This conductive area together with the dielectric material creates a capacitor referenced to a system ground. Touching the dielectric results in a change in electrical capacitance. A sensor coupled to the electrode uses a capacitive sensing method to measure the change and thereby detect a user touch.

### SUMMARY

Various aspects of the disclosure are defined in the accompanying claims. In a first aspect there is provided a capacitive touch sensor comprising: a substrate; a dielectric layer; a first coil spring electrode arranged between the substrate and the dielectric layer; a second coil spring electrode arranged between the substrate and the dielectric layer; wherein the first coil spring electrode is located within a perimeter of the second coil spring electrode.

In one or more embodiments, the first coil spring electrode diameter may be less than the second coil spring electrode diameter.

In one or more embodiments, the first coil spring electrode and second coil spring electrode may be arranged co-axially.

In one or more embodiments, the capacitive touch sensor may further comprise a first metal cap connected to the first coil spring electrode and a second metal cap connected to the second coil spring electrode; wherein the first metal cap is arranged between the first coil spring electrode and the dielectric layer and the second metal cap is arranged between the second coil spring electrode and the dielectric layer.

In one or more embodiments, the capacitive touch sensor may further comprise a spacer arranged between the first metal cap and the second metal cap.

In one or more embodiments, the second metal cap may comprise a metal ring.

In one or more embodiments, the substrate may comprise a printed circuit board.

In one or more embodiments, a first end of each of the first coil spring electrode and the second coil spring electrode may be configured as electrode terminals, wherein the electrode terminals are attached to the substrate.

In one or more embodiments, the capacitive touch sensor may further comprise, a touch sensor controller coupled to at least one of the first coil spring electrode and the second coil spring electrode, wherein the touch sensor controller is configured to determine a capacitance value by one or more charge transfer scan cycles applied to at least one of the first coil spring electrode and second coil spring electrode and to determine a touch dependent on the capacitance value.

In one or more embodiments, the first coil spring electrode may be configured to be connected to a touch sensor controller first terminal and the second coil spring electrode may be configured to be connected to a ground.

In one or more embodiments, the first coil spring electrode may be configured to be connected to a touch sensor controller first terminal and the second coil spring electrode may be configured to be connected to a touch sensor controller second terminal wherein the touch sensor controller may be configured to determine a capacitance value by a one or more charge transfer scan cycles applied to the first coil spring electrode and second coil spring electrode and to determine a touch dependent on the capacitance value.

In one or more embodiments, the touch sensor controller may be configured to apply one or more charge pulses to the first coil spring electrode and apply a one or more pulses for active shielding to the second coil spring electrode.

In one or more embodiments, the touch sensor controller may be configured to detect a change in capacitance value in a charge transfer scan cycles by applying a pulse to the first coil spring electrode and detecting an output from the second coil spring electrode and to determine a touch status from the detected change in capacitance value.

One or more embodiments of the capacitive touch sensor may be included in a touch control panel.

In a second aspect, there is provided a capacitive touch sensor comprising: a substrate; a dielectric layer; an inner electrode and an outer electrode arranged between the substrate and the dielectric layer; wherein the inner electrode and the outer electrode each comprise a helical spring.

In one or more embodiments, the helical spring diameter of the inner electrode may be less than helical spring diameter of the outer electrode.

In one or more embodiments, the helical springs of the inner electrode and outer electrode may be arranged co-axially.

In one or more embodiments, the capacitive touch sensor may further comprise a first metal region and a second metal region; wherein the first metal region is arranged between the helical spring of the inner electrode and the dielectric layer and the second metal region is arranged between the helical spring of the inner electrode and the dielectric layer.

In one or more embodiments, the capacitive touch sensor may further comprise a spacer arranged between the first metal region and the second metal region.

In one or more embodiments, the capacitive touch sensor may further comprise a touch sensor controller coupled to at least one of the inner electrode and the outer electrode, wherein the touch sensor controller is configured to determine a capacitance value by one or more charge transfer scans applied at least one of the inner electrode and the outer electrode and to determine a touch dependent on the capacitance value.

### BRIEF DESCRIPTION OF THE DRAWINGS

In the figures and description like reference numerals refer to like features. Embodiments are now described in detail, by way of example only, illustrated by the accompanying drawings in which:
Figure 1A shows a typical capacitive sensor.
Figure 1B shows a plan view of the capacitive sensor of figure 1A.
Figure 2A shows a typical touch sensor including the capacitive sensor of figures 1A and 1B.
Figures 2B and 2C illustrates a graph showing the signal at the input of the comparator and the output of the counter of the touch sensor of figure 2A.
Figure 3A shows a capacitive sensor according to an embodiment.
Figure 3B shows a plan view of the capacitive sensor of figure 3A.
Figure 4A illustrates a illustrates a touch sensor including the capacitive sensor of figures 3A and Figure 3B according to an embodiment.
Figures 4B and 4C illustrates a graph showing the signal at the input of the comparator and the output of the counter of the touch sensor of figure 4A.
Figure 5A shows a touch sensor configured for sensing mutual capacitance including the capacitive sensor of figures 3A and 3B according to an embodiment.
Figure 5B shows a touch sensor including the capacitive sensor of figures 3A and 3B according to an embodiment.
Figure 6A shows a use case of the touch sensor of figure 4A.
Figures 6B, 6C and 6D show use cases of the touch sensor of figure 4B.

### DETAILED DESCRIPTION OF EMBODIMENTS

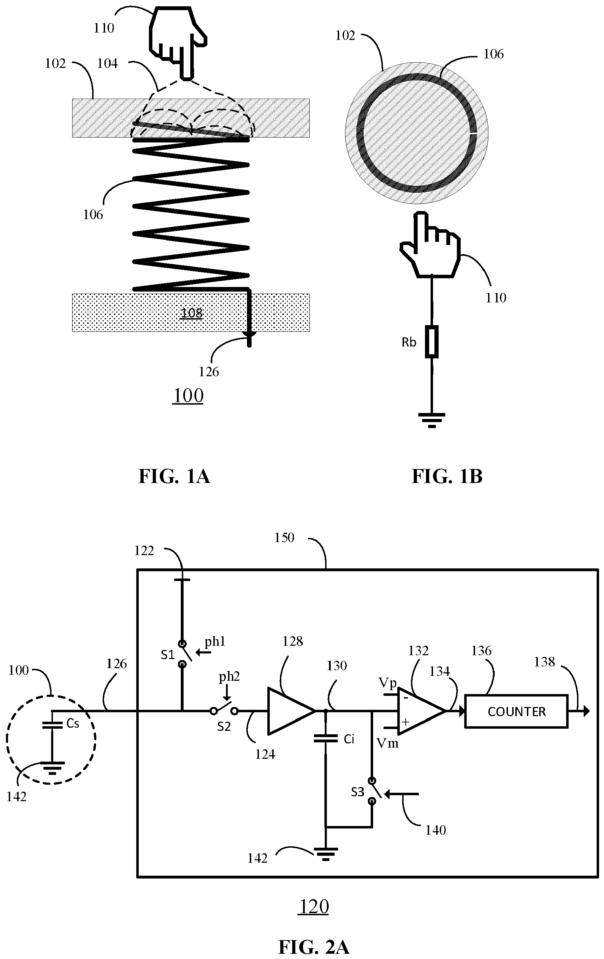

Figure 1A shows a typical capacitive touch sensor 100. The capacitive touch sensor 100 is implemented as a button and may be used in various control panels for example or other human machine interfaces. This is illustrated in the plan view figure 1B of capacitive touch sensor 100. The capacitive touch sensor 100 includes a substrate 108 which is typically a printed circuit board. An electrode 106 formed by a coil spring hereinafter referred to as a coil spring electrode has one end attached to the printed circuit board 108 and the other end connected to a dielectric 102. The coil spring electrode 106 is arranged so that it separates the dielectric 102 from the printed circuit board 108. The coil spring electrode 106 together with the dielectric 102 creates a capacitor referenced to a system ground. When a user 110 presses the dielectric 102 the electric field 104 changes altering the capacitance of the capacitive touch sensor 100. The change in electrical capacitance is due to effectively increasing the dielectric of the original capacitor and adding a second conductive area that is effectively grounded via the user finger 110 shown by the equivalent circuit including resistance Rb connected to ground.

The terminal 126 of the coil spring electrode 106 connected to the printed circuit board is connected to further circuitry ( not shown) which can detect the change of capacitance and generate an indication that the button has been pressed.

Figure 2A shows an example implementation of a touch sensor 120 including the capacitive touch sensor 100 and a touch sensor controller 150. The capacitive touch sensor 100 may have an effective self-capacitance Cs coupled between ground and an electrode terminal. A first terminal of first switch S1 is connected to the supply 122. A second terminal of the first switch S1 is connected to the electrode terminal 126 and a first terminal of a second switch S2. The second terminal of the second switch S2 is connected to the amplifier input 124 of a transconductance amplifier 128. The amplifier output 130 of the transconductance amplifier 128 may be connected to a first terminal of capacitor Ci and an input of comparator 132. A second terminal of capacitor Ci may be connected to ground 142. A first terminal of third switch S3 may be connected to amplifier output 130. A second terminal of third switch S3 may be connected to ground 142. The switch S3 may have a control input 140. A counter 136 has an input connected to the comparator output 134. The counter 136 has a counter output 138.

In operation, the touch sensor controller 150 detects a change in capacitance of the capacitor touch sensor 100 by one or more charge transfer scan cycles. In a charge transfer scan cycle, a sampling clock including non-overlapping ph1 (sample phase) and ph2 (transfer phase ) is controlled to charge the electrode capacitor Cs by closing the first switch S1 and opening the second switch S2 and then to transfer the charge to internal integration capacitor Ci through transconductance amplifier circuit 128 by opening switch S1 and closing the second switch S2. The switch S3 is open during the scanning cycle but may be closed at the end of the scan cycle to discharge the integration capacitor Ci before the next scanning cycle begins. The control of the switches S1,S2 and S3 may be performed by a controller (not shown). A clock (not shown) is provided to the counter 136. The counter 136 counts a number of clock cycles during which the voltage at the amplifier output 130 corresponding to the integration capacitor voltage V_{Ci} increases from a first reference voltage Vm to a second reference voltage Vp. The count value provides a measure of the capacitance value of the electrode capacitance Cs.

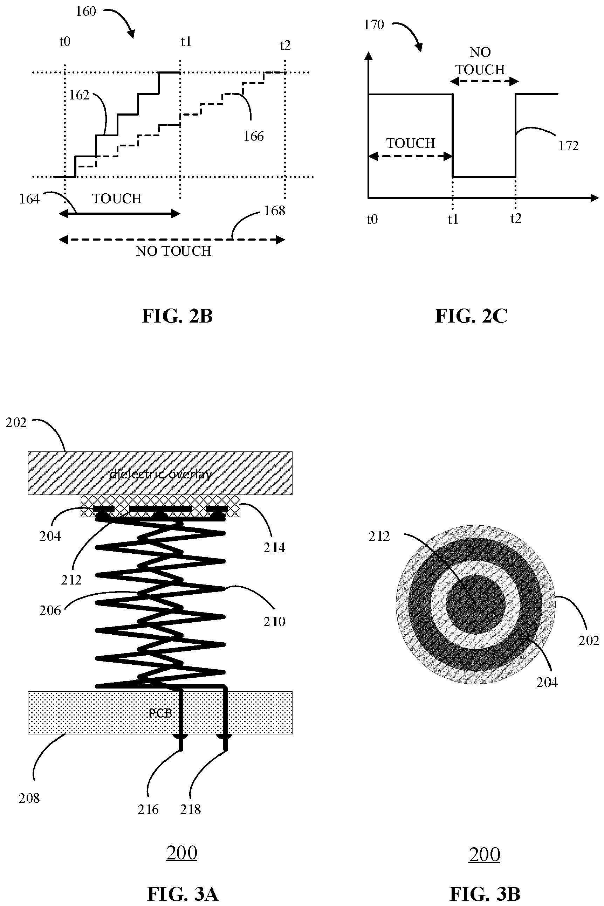

Figure 2B is a graph 160 showing the change in VCi during a scan cycle. Starting at time t0, the stepped saw tooth 162, 166 is generated at the amplifier output 130. The integration capacitor voltage Vci is detected by comparator 132. When Vci surpasses the positive reference voltage Vp, integration capacitor Ci is discharged to the negative reference Vm by closing switch S3. The next scanning cycle may then start.. When the capacitive touch sensor 100 is touched by a user, the capacitance value of the capacitance Cs will increase. Consequently, the Ci charge step height increases and then the number of saw tooth ramp up steps is reduced. As shown in graph 160, the touch status indicating a touch may correspond to a scan time 164 of time t1 or less and the touch status indicating no touch may correspond to a scan time 168 of between t1 and t2. The (digital) counter 136 accumulates the number of charging "steps" required to charge Ci up to the positive reference voltage Vp. Figure 2C shows the counter output 170 which may be a signal 172 which may be processed further by for example software executing on a microprocessor or further hardware logic circuitry to determine touch status according to the time duration. It will be appreciated that other methods of determining the change in capacitance of the capacitive touch sensor 100 may also be used.

Figure 3A shows a capacitive touch sensor 200 according to an embodiment. Figure 3B shows the top view of the capacitive touch sensor 200. The capacitive touch sensor 200 includes a substrate which may be a print circuit board (PCB) 208, an inner coil spring electrode 206 and an outer coil spring electrode 210 which surrounds the inner coil spring electrode 206. The inner coil spring electrode 206 is therefore located within the perimeter of the outer coil spring electrode 210. The term perimeter as used in this context refers to the perimeter defined by the shape of the spring when viewed in plan-view such as the top view of figure 3B. For the example illustrated in figures 3A and 43b, the perimeter is defined by the circumference of the circle. The term coil spring may be considered to include all helical springs which may be circular or non-circular. For circular springs the first or inner coil spring electrode 206 has a smaller coil spring diameter than the second or outer coil spring electrode 210. For other helical spring shapes for example a square when viewed from an end of the spring, then the length of the side of the inner coil spring electrode is less than the length of a side of the outer coil spring. The inner coil spring electrode 206 and the outer coil spring electrode 210 are arranged co-axially between the printed circuit board 208 and a dielectric layer 202. A first electrode terminal 216 of the first coil spring electrode 206 is connected to the printed circuit board 208. A first electrode terminal 218 of the second spring electrode 210 is connected to the printed circuit board 208.

The inner coil spring electrode 206 may have an inner spring cap 212 which may be a metallic cap attached to the inner spring serving as a first electrode plate so providing a metal region between the inner coil spring electrode 206 and the dielectric layer 202. The outer coil spring electrode 210 may have an outer spring cap 204 serving as the second electrode plate. In some examples this may be a metallic ring providing a metal region between the outer spring cap 204 . In some examples, the inner spring cap 212 and outer spring cap 204 may be omitted so that the dielectric layer 202 is in direct contact with the dielectric layer 202. The capacitive touch sensor 200 may further have a dielectric spacer 214 to separate the inner coil spring electrode 206 and the outer coil spring electrode 210 and prevent unwanted movement and to avoid short-circuit between inner coil spring electrode 206 and an outer coil spring electrode 210. The dielectric spacer 214 may for example be formed of molded resin, plastic or some other dielectric. In some examples, the dielectric spacer 214 may be omitted. In some examples, the dielectric spacer 214 may be a further dielectric layer adjacent to dielectric layer 202. In some examples, the dielectric spacer 214 may be part of the dielectric layer 202.

The capacitive touch sensor 200 has a co-axial dual spring electrode connected on a PCB for implementing a capacitive touch sensor for electronic control panels. By including two electrodes in the touch sensor, the two independent electrical connections may be used by sensor for compensation purposes, while the "mechanical" benefit of the flexible spring contact is still maintained.

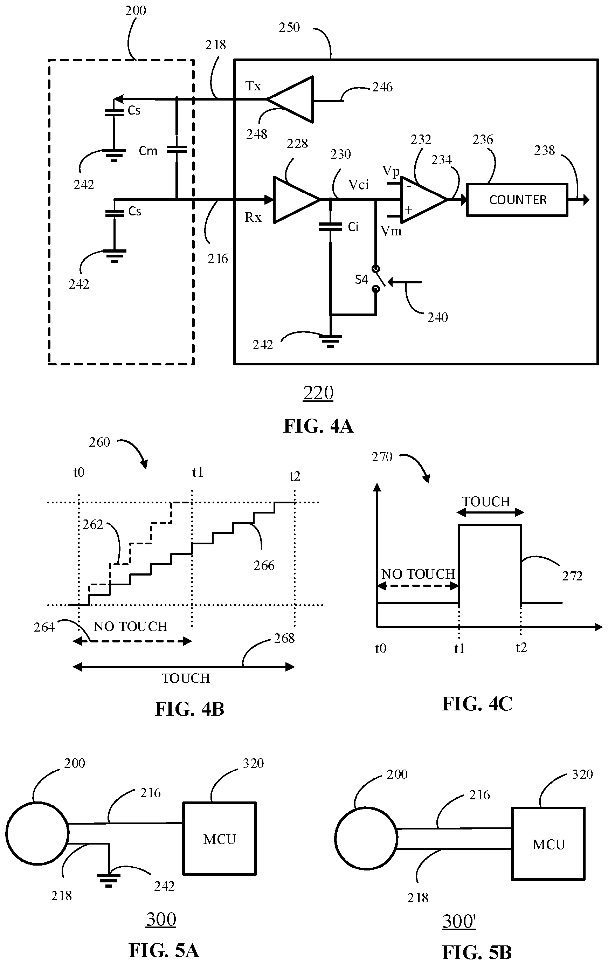

Figure 4A shows an example implementation of a touch sensor 220 including the capacitive touch sensor 200 and a touch sensor controller 250 for detecting changes in mutual capacitance Cm between the two electrodes of the capacitive touch sensor 200. Each coil spring electrode 206,210 of the capacitive touch sensor 200 may have an effective self-capacitance Cs coupled between a reference potential 242 which is typically a ground and a respective electrode terminal 216, 218. A first electrode terminal 216 may be connected to the amplifier input of a transconductance amplifier 228. The amplifier output 230 of the transconductance amplifier 228 may be connected to a first terminal of capacitor Ci and an input of comparator 232. A second terminal of capacitor Ci may be connected to ground 242. A first terminal of switch S4 may be connected to amplifier output 230. A second terminal of third switch S4 may be connected to ground 242. The switch S4 may have a control input 240. A counter 236 has an input connected to the comparator output 234. The counter 236 has a counter output 238. The touch sensor controller 250 also includes a transmitter buffer 248 having an input 246 and an output connected to the second electrode terminal 218.

In operation, the touch sensor controller 250 detects a change in capacitance of the capacitive touch sensor 200 by one or more charge transfer scan cycles. The transmitter 248 receives charge pulses from a pulse generator ( not shown) which is decoupled by the mutual capacitance Cm and then received by the (receiver) amplifier 228 side. The amplifier 228 amplifies the signal with a noise cancellation method which is similar to the transconductance amplifier charge transfer circuit od the touch sensor controller 150. In this case, the number of steps rises (as the steps are smaller) when there is a touch compared to no, because the charge received on Rx input is decreased, due the fact that the part of the charge is "stolen" by a touch.

This difference is shown in figures 4B and 4C. Figure 4B is a graph 260 showing the change in VCi during a scan cycle. Starting at time t0, the stepped saw tooth 262, 266 is generated at amplifier output 230. Vci is detected by comparator 232. When Vci surpasses the positive reference voltage Vp, Ci is discharged to the negative reference Vm by closing switch S4. The next scanning cycle may then start. When the capacitive touch sensor 200 is touched by a user, the capacitance value of the capacitance Cm will decrease. Consequently, the Ci charge step height decreases and then the number of saw tooth ramp up steps is increased. As shown in graph 260, no touch may correspond to a scan time 264 of time t1 or less and a touch may correspond to a scan time 268 of between t1 and t2. The (digital) counter 236 accumulates the number of charging "steps". The counter output 270 may be a signal 272 which may be used by software to detect touch according to the time duration.

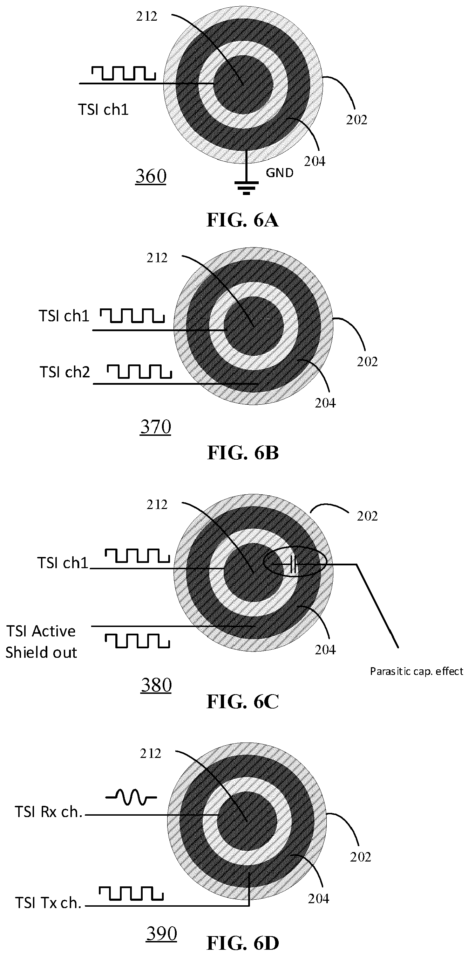

Figure 5A shows a touch sensor 300 including the capacitive touch sensor 200 and a microcontroller 320 which may be used to implement a touch sensor controller such as touch sensor controller 150. The first electrode terminal 216 is connected to ground 222. The second electrode terminal 218 is connected to a touch sensor interface of a microcontroller 320 which may implement for example the touch sensor controller 150 or some other method to determine a change in capacitance of the capacitive touch sensor 200. Figure 4B shows a touch sensor 300' in a slightly different configuration with the first electrode terminal 216 connected to a first touch sensor interface (TSI) of the microcontroller 320 and a second electrode terminal 218 is connected to a second touch sensor interface of the microcontroller 320. The touch sensors 300, 300' may implement different use cases illustrated in figures 6A to 6D.

Figure 6A shows a use case 360 which may be implemented by touch sensor 300. In this example the outer electrode is grounded i.e. the second electrode terminal 218 is connected to the ground. A TSI of the microcontroller may be used to detect a change in capacitance by charging and discharging the first coil spring electrode 206 and then sensing a change in charge and discharge time similarly to as described for touch sensor 120.

Figure 6B shows a use case 370 which may be implemented by touch sensor 300'. In this use case both electrodes are actively scanned and by a respective TSI channel. Each TSI interface of the microcontroller may be used to detect changes in the capacitance of each of the electrodes by charging and discharging the respective first coil spring electrode 206 and the second coil spring electrode 210 and sensing a change in charge and discharge time independently for each of the electrodes similarly to as described for touch sensor 120.

Figure 6C shows the use case 380 which may be implemented by touch sensor 300' to implement a so-called active shield method familiar to the skilled person. In this use case 380, a first TSI interface of the microcontroller may be used to detect changes in the capacitance of by one or more scans of the respective first coil spring electrode 206 and sensing a change in charge time of an integration capacitor similarly as described for touch sensor 120. A second TSI interface of the microcontroller may be used to apply an active shielding signal The driven-shield signal is a buffered "copy" of the sensor-charging signal having the same sample amplitude, frequency and phase. The effect of any liquid droplets on the capacitor sensor section is reduced, because the shield electrode, in this case the second coil spring electrode is driven with a voltage which is the same as the sensor-switching signal, the parasitic capacitance added by a liquid droplet when on the touch surface will be nullified. Preferably for the best water-tolerance performance, the driven shield signal has the same "shape" i.e. voltage and phase as the sensor-switching signal. Moreover, an active shield may reduce the intrinsic capacitance of the PCB, which may increase the overall sensitivity of the standard touch electrodes. This may be beneficial for instance for proximity sensing.

Figure 6D shows the use case 390 for sensing mutual capacitance which may be implemented by touch sensor 300'. In this use case 290 a first TSI interface of the microcontroller may be used to charge and discharging the outer coil spring electrode 210 and a second TSI channel coupled to the inner coils spring electrode may sense a change in charge and discharge time. This use case detects a change in mutual capacitance between the electrodes resulting from a user contact similarly to touch sensor 220.

Embodiments include a capacitive touch sensor arrangement including two spring electrode. One spring (inner spring) with smaller diameter is placed inside a second spring with larger diameter (outer spring). Both springs together function as single capacitive touch sensor, which may have several main application advantages and may be used in the following scenarios improving the sensor performance and robustness against the parasitic environmental effects like a liquid presence on the top of the sensor or control panel. Embodiments of the touch sensor may be used in touch-sensing based control applications including, but not limited to, human machine interface (HMI) panels for Appliances such as white goods, cookers, ovens, heating, ventilation and air conditioning (HVAC) controllers, automotive cabin controls, medical and industrial devices. In other examples, the touch sensor may be included in touch control panels with improved water droplet immunity such as whirlpool control panels, induction hobs, shower control panels.

A capacitive touch sensor is described having two spring electrodes. One spring (inner spring) with smaller diameter is placed inside a second spring with larger diameter (outer spring). Both springs together function as single capacitive touch sensor, which may improve the sensor performance and robustness against parasitic environmental effects such as the presence of liquid on the sensor or control panel.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A capacitive touch sensor comprising:
a substrate;
a dielectric layer;
a first coil spring electrode arranged between the substrate and the dielectric layer;
a second coil spring electrode arranged between the substrate and the dielectric layer;
wherein the first coil spring electrode is located within a perimeter of the second coil spring electrode.

2. The capacitive touch sensor of claim 1 wherein the first coil spring electrode diameter is less than the second coil spring electrode diameter.

3. The capacitive touch sensor of any preceding claim wherein the first coil spring electrode and second coil spring electrode are arranged co-axially.

4. The capacitive touch sensor of any preceding claim further comprising a first metal cap connected to the first coil spring electrode and a second metal cap connected to the second coil spring electrode; wherein the first metal cap is arranged between the first coil spring electrode and the dielectric layer and the second metal cap is arranged between the second coil spring electrode and the dielectric layer.

5. The capacitive touch sensor of claim 4 further comprising a spacer arranged between the first metal cap and the second metal cap.

6. The capacitive touch sensor of claim 4 or 5 wherein the second metal cap comprises a metal ring.

7. The capacitive touch sensor of any preceding claim wherein the substrate comprises a printed circuit board.

8. The capacitive touch sensor of any preceding claim wherein a first end of each of the first coil spring electrode and the second coil spring electrode are configured as electrode terminals, wherein the electrode terminals are attached to the substrate.

9. The capacitive touch sensor of any preceding claim further comprising a touch sensor controller coupled to at least one of the first coil spring electrode and the second coil spring electrode, wherein the touch sensor controller is configured to determine a capacitance value by one or more charge transfer scan cycles applied to at least one of the first coil spring electrode and second coil spring electrode and to determine a touch dependent on the capacitance value.

10. The capacitive touch sensor of claim 9 wherein the first coil spring electrode is configured to be connected to a touch sensor controller first terminal and the second coil spring electrode is configured to be connected to a ground.

11. The capacitive touch sensor of claim 9 wherein the first coil spring electrode is configured to be connected to a touch sensor controller first terminal and the second coil spring electrode is configured to be connected to a touch sensor controller second terminal wherein the touch sensor controller is configured to determine a capacitance value by a one or more charge transfer scan cycles applied to the first coil spring electrode and second coil spring electrode and to determine a touch dependent on the capacitance value.

12. The capacitive touch sensor of claim 9 wherein the touch sensor controller is configured to apply one or more charge pulses to the first coil spring electrode and apply one or more pulses for active shielding to the second coil spring electrode.

13. The capacitive touch sensor of claim 9 wherein the touch sensor controller is configured to detect a change in capacitance value in a charge transfer scan cycle by:
applying a pulse to the first coil spring electrode, and detecting an output from the second coil spring electrode in response to the applied pulse; and
to determine a touch status from the detected change in capacitance value.

14. A touch control panel comprising the capacitive touch sensor of any preceding claim.

15. A capacitive touch sensor comprising:
a substrate;
a dielectric layer;
an inner electrode and an outer electrode arranged between the substrate and the dielectric layer;
wherein the inner electrode and the outer electrode each comprise a helical spring.
